**Europäisches Patentamt**

**European Patent Office**

**Office européen des brevets**

(11) Veröffentlichungsnummer: **0 456 825 A1**

## (12) EUROPÄISCHE PATENTANMELDUNG
### veröffentlicht nach Art. 158 Abs. 3 EPÜ

(21) Anmeldenummer: 90905344.9

(22) Anmeldetag: 29.12.89

(86) Internationale Anmeldenummer:
**PCT/SU89/00340**

(87) Internationale Veröffentlichungsnummer:
**WO 91/08593 (13.06.91 91/13)**

(51) Int. Cl.5: **H01L 29/02**

(30) Priorität: 24.11.89 SU 4759168

(43) Veröffentlichungstag der Anmeldung:
**21.11.91 Patentblatt 91/47**

(84) Benannte Vertragsstaaten:
**DE FR GB IT SE**

(71) Anmelder: **INSTITUT PROBLEM UPRAVLENIA AKADEMII NAUK SSSR**
ul. Profsojuznaya, 65
Moscow, 117342(SU)

(72) Erfinder: **ZOTOV, Vladislav Dmitrievich**
ul. Serpukhovskoi Val, 9-20

Moscow, 113191(SU)
Erfinder: **BODROV, Vladimir Nikolaevich**
ul. Vinnitskaya, 13-84
Moscow, 117192(SU)
Erfinder: **VINOGRADOVA, Elena Petrovna**
ul. Bestuzhevykh, 7v-20
Moscow, 127577(SU)
Erfinder: **SEROV, Anatoly Trofimovich**
Dmitrovskoe shosse, 13-3-23
Moscow, 127434(SU)

(74) Vertreter: **Nix, Frank Arnold, Dr.**
Kröckelbergstrasse 15
W-6200 Wiesbaden(DE)

(54) **HALBLEITERSTRUKTUREN, VERFAHREN ZUR STEUERUNG VON DEREN LEITFAHIGKEIT UND FUHLELEMENTE AUF DER BASIS DIESER HALBLEITERSTRUKTUREN.**

(57) Halbleiterstruktur, in der sich die Beimischungskonzentrationen in einem solchen Verhältnis befinden, dass die Anzahl von durch die Beimischung des ersten Leitfähigkeitstyps erzeugten, durch eine dritte Beimischung kompensierten Ladungsträgern der Anzahl von durch die Beimischung eines zweiten Leitfähigkeitstyps erzeugten Ladungsträgern in wesentlichen gleich ist oder diese um maximal eine Grössenordnung überschreitet. Im Verfahren zur Steuerung der Leitfähigkeit der Halbleiterstruktur (1) wird der Stromwert bei der Stromkanalbildung in einem Bereich eingestellt, bei dem in der Halbleiterstruktur (1) eine periodische Änderung der Leitfähigkeit im Stromkanal entsteht, die zu einer Änderung der Leitfähigkeit der gesamten Halbleiterstruktur (1) führt, und am Ausgang der Halbleiterstruktur (1) eine Impulsfolge erzeugt, wobei für die Strukturen (1), bei denen die Anzahl der durch die Beimischung des ersten Leitfähigkeitstyps erzeugten, durch eine dritte Beimischung kompensierten Ladungsträger die Anzahl der durch die Beimischung des zweiten Leitungstyps erzeugten Ladungsträger um nicht mehr als eine Grössenordnung überschreitet, auf die Struktur (1) bei der Stromkanalbildung eingewirkt werden muss. Die Frequenz der Leitfähigkeitsänderung in der Stromkanalzone der Struktur (1) wird durch mindestens eine äussere Einwirkung gesteuert.

EP 0 456 825 A1

FIG.2

## Technisches Gebiet

Die vorliegende Erfindung bezieht sich auf die Halbleitertechnik und betrifft insbesondere Halbleiterstrukturen, Verfahren zur Steuerung von deren Leitfähigkeit und Fühlelemente auf der Basis dieser Halbleiterstrukturen.

## Zugrundeliegender Stand der Technik

Bei der Verwendung Von Halbleiterstrukturen ist die Umwandlung der Eingangsinformation und die Gewinnung eines mit der Grösse der Eingangseinwirkung funktionell zusammenhängenden Signals eine der wichtigsten Aufgaben. Die dabei entstehenden Hauptprobleme sind die Gewährleistung der Einfachheit und der Genauigkeit der Umwandlung und die Gewinnung eines Ausgangssignals, dessen Pegel und Verlauf für die Weiterverarbeitung am besten geeignet sind.

In den meisten heutigen Halbleiterstrukturen erfolgt die Umwandlung der Eingangswirkung durch Steuerung der Leitung. *

Es sind Halbleiterstrukturen, Verfahren zur Steuerung ihrer Leitung durch ein Magnetfeld sowie Fühlelemente auf der Basis dieser Strukturen bekannt (G.A. Egiazaryan, V.I. Stafeev "Magnitodiody, magnitotranzistory i ikh primenenie", 1987, Moskau, Verlag "Radio i svyaz", S.12,13).

Die Halbleiterstruktur wird aus einem hochohmigen Werkstoff mit einer der Eigenleitung naheliegenden Leitung erzeugt und stellt einen $p^+n$-Übergang dar, bei dem die Länge des n-Bereichs die Länge einer Diffusionsverschiebung von Ladungsträgern um ein Vielfaches übertrifft.

Das im Fühlelement realisierte Steuerverfahren für die Leitung einer derartigen Halbleiterstruktur besteht darin, dass das Fühlelement an eine Speisequelle in Durchlassrichtung geschaltet wird. Dann wird an das Fühlelement ein Magnetfeld (äussere Einwirkung) angelegt, das zu dem durch das Fühlelement fliessenden Strom senkrecht gerichtet ist und die Leitfähigkeit des n-Bereichs gesteuert. Die Änderung der Leitfähigkeit des n-Bereichs bewirkt eine Abnahme des durch das Fühlelement fliessenden Stroms, nach dem die Stärke des angelegten Magnetfeldes ermittelt wird.

Die Fühlelemente auf der Basis einer derartigen Halbleiterstruktur zeichnen sich aber durch ein analoges Ausgangssignal (Änderung des Stromwertes) mit einer in der Regel geringen Amplitude aus, das einer Nachverstärkung und bei der Arbeit mit Computern einer Analog-Digital-Umwandlung bedarf. Ausserdem zeichnet sich das analoge Ausgangssignal durch eine niedrige Störsicherheit aus,weshalb die Messgenauigkeit sinkt,und beim Betrieb unter Störeinflüssen und bei einigem Abstand des Fühlelements von der Ausgangssignalverarbeitungsanlage müssen spezielle Störschutzmassnahmen getroffen werden.

Es sind pn-Halbleiterstrukturen, ein Verfahren zur Steuerung ihrer Leitung durch Licht und Fühlelemente auf der Basis dieser Strukturen (N.B. Zaletaev, K.M. Kulikov, V.P. Nikiforova, V.I. Stafeev "Vliyanie osveschenia na svoistva S-diodov iz germania s primesju zolota". -"Fizika i tekhnika poluprovodnikov", Bd. 8, 1974, H. 1, S. 39 bis 44) bekannt.

Die Halbleiterstruktur ist aus n-leitendem Germanium hergestellt, das mit Gold dotiert und mit Antimon kompensiert ist. Die Goldkonzentration $N_{Au}$ steht zur Antimonkonzentration $N_{Sb}$ in folgendem Verhältnis:

$$N_{Au} < N_{Sb} < 2N_{Au}$$

Die Länge des n-Bereichs ist um ein Mehrfaches grösser als die Länge der Diffusionsverschiebung der Ladungsträger.

Das Fühlelement auf der Basis einer derartigen Halbleiterstruktur hat eine S-förmige Stromspannungskennline. Das Fühlelement wird an eine Speisequelle in Durchlassrichtung angeschlossen und einer Lichtwirkung (als äussere Einwirkung) unterzogen. Unter der Lichtwirkung ändert sich die Leitung der Ausgangs-Halbleiterstruktur, was zu einer Änderung der Amplitude des Ausgangssignals führt. Durch die Zuführung der obengenannten Beimischungen in die Struktur in einem vorgegebenen Verhältnis und durch Verlängerung des n-Bereichs wird eine Erhöhung der Lichtempfindlichkeit erzielt.

Das Ausgangssignal eines derartigen Fühlelements weist aber eine Analogform auf, und eine genaue Messung des Lichtsignals ist aus vorstehend beschriebenen Gründen erschwert.

Es ist auch ein Halbleiter-Fühlelement bekannt, das auf der Basis einer Halbleiterstruktur mit einer S-förmigen Stromspannungskennlinie erzeugt ist, auf deren gegenüberliegenden Flächen Kontakte gebildet sind, wobei einer der Kontakte in Form eines gleichschenkligen Dreiecks mit einer in die Tiefe der Struktur gerichteten Spitze (SU, A, 1161831) ausgeführt ist.

Das Steuerverfahren für die Leitung der im Fühlelement verwendeten Halbleiterstruktur geschieht wie folgt. An das Fühlelement wird eine Spannung oberhalb eines bestimmten Schwellenwertes angelegt, wodurch ein Stromkanal, in der Regel im Zentralteil der Halbleiterstruktur, gegenüber der Spitze der dreieckigen Elektrode gebildet

---

* Anm. des Übersetzers:     hier und nachfolgend     im Sinne von "Leitfähigkeit"

wird. Dann wird auf das Fühlelement von aussen eingewirkt - daran ein Magnetfeld angelegt, wodurch die Leitung der Struktur geändert wird. Hierbei wird der Stromkanal von seinem Entstehungsort um einiges abgelenkt. Diese Ablenkung führt zu einer Verlängerung der Struktur in Stromrichtung, weshalb neben einer Trägerbahnkrümmung eine zusätzliche Widerstandszunahme der Halbleiterstruktur geschieht, und die Empfindlichkeit der Struktur nimmt auch zu.

Ein derartiges Fühlelement weist aber ein analoges Ausgangssignal auf, und dessen Messung bereitet dieselben Schwierigkeiten, die vorstehend geschildert sind. Darüber hinaus ist die Bildung eines Kontaktes in Dreieckform technologisch schwer ausführbar, was den Einsatz solch eines Fühlelements in Messgeräten kompliziert.

Am nächsten liegt nach dem technischen Wesen den erfindungsgemässen Halbleiterstrukturen, Steuerverfahren für deren Leitung und den Fühlelementen auf der Basis dieser Halbleiterstrukturen eine pn-Halbleiterstruktur, die aus hochohmigem Silizium hergestellt ist, das durch eine tiefe energetische Iridiumbeimischung kompensiert ist (S.A. Azimov, M.S. Junusov, B.V. Umarov "Magnitochuvstvitelnye diody iz kremnia, kompensirovannogo iridiem". - Fizika i tekhnika poluprovodnikov", Bd. 12, H. 6, 1978, S. 1187, 1188). Der pn-Übergang in der Halbleiterstruktur ist durch Einlegieren einer Gold-Antimon-Legierung in eine Siliziumscheibe erzeugt. Im Fühlelement auf der Basis dieser Halbleiterstruktur liegen die Kontakte auf den gegenüberliegenden Seiten der Siliziumscheibe. Derartige Halbleiterstrukturen und Fühlelemente weisen eine S-förmige Stromspannungskennlinie auf. Das Steuerverfahren für das Fühlelement auf der Basis einer derartigen Halbleiterstruktur besteht in folgendem. Das Fühlelement wird an eine Speisequelle in Durchlassrichtung geschaltet. Es wird eine Speisespannung eingestellt, bei der das Element in einen Zustand mit einem negativen differentiellen Widerstand übergeht. Man legt an das Fühlelement ein Magnetfeld (äussere Wirkung) an, das senkrecht zum Strom gerichtet ist, wodurch eine Änderung der Leitfähigkeit der Halbleiterstruktur hervorgerufen wird. Nach der Spannungsänderung am Fühlelement wird die magnetische Feldstärke bestimmt.

Diese Struktur, das Verfahren und das Fühlelement gestatten es, ein Ausgangssignal mit einem recht hohen Pegel zu erhalten, das nicht immer einer Verstärkung bedarf. Die Art des Ausgangssignals ist aber analog, weshalb die Genauigkeit und die Störsicherheit der Messungen nicht hoch sind und die Signalverarbeitung recht schwierig ist.

Offenbarung der Erfindung

Der Erfindung liegt die Aufgabe zugrunde, derartige Halbleiterstrukturen, Steuerverfahren für deren Leitung und Fühlelemente auf der Basis dieser Strukturen zu entwickeln, die durch die Wahl des Verhältnisses der Beimischungskonzentrationen zueinander in den Halbleiterstrukturen und durch die Steuerung der Frequenz ihrer Leitfähigkeitsänderung es erlauben, am Ausgang der Fühlelemente ein Impulsfrequenzsignal mit einer hohen Amplitude zu erzeugen und konstruktiv einfache Halbleiterwandler für verschiedene physikalische Grössen beispielsweise ein Magnetfeld, mechanische Kraft, Lichtstrahlung, Generatoren mit Selbsterregung, Gleichspannungs-Frequenz-Wandler u.a. zu schaffen, die sich durch eine hohe Genauigkeit und Sicherheit der Messung und der Umwandlung auszeichnen.

Die gestellte Aufgabe wird dadurch gelöst, dass in einer Helbleiterstruktur, die aus einem mit der Beimischung eines Leitfähigkeitstyps dotierten Werkstoff hergestellt und in der ein pn-Übergang durch Einlegieren der Beimischung des entgegengesetzten Leitfähigkeitstyps erzeugt ist, wobei die Beimischung des ersten Leitfähigkeitstyps durch Einlegieren einer dritten Beimischung kompensiert ist, die in der Halbleiterstruktur tiefliegende Energieniveaus bildet, gemäss der Erfindung sich die Beimischungskonzentrationen in der Halbleiterstruktur in einem solchen Verhältnis befinden, bei dem die Anzahl der durch die Beimischungen des ersten Leitfähigkeitstyps erzeugten, durch die Beimischungen kompensierten Ladungsträger der Anzahl der durch die Beimischungen des zweiten Leitfähigkeitstyps erzeugten Ladungsträger im Wesentlichen gleich ist oder sie um maximal eine Grössenordnung überschreitet.

Es ist zweckmässig, als Material der Halbleiterstruktur Silizium zu wählen, das mit einer den n-Leitfähigkeitstyp erzeugenden Beimischung dotiert ist, als welche Phosphor einzusetzen ist, und als eine den p-Leitfähigkeitstyp erzeugende Beimischung Aluminium zu verwenden ist, wobei es von Vorteil ist, die den n-Leitfähigkeitstyp erzeugende Beimischung durch eine dritte Beimischung zu kompensieren, die in der Halbleiterstruktur tiefgehende Energieniveaus bilden, und als solche Gold zu benutzen.

Es ist auch möglich, als die dritte Beimischung, die in der Struktur tiefliegende Energieniveaus bildet, Zink einzusetzen.

Das Verhältnis der Beimischungskonzentrationen in der Halbleiterstruktur, bei dem die Anzahl der durch die Beimischung des ersten Leitfähigkeitstyps erzeugten, durch die dritte Beimischung kompensierten Ladungsträger im wesentlichen gleich der Anzahl der durch die Beimischung des zweiten Leitungstyps erzeugten Ladungsträger ist, sorgt für die Entstehung periodischer Änderungen der Leitfähigkeit der Halbleiterstruktur in der Stromkanalzone unter bestimmten Bedingungen. Bei der Schaffung der Halbleitergeräte auf der Basis einer derartigen Halbleiterstruktur wird auf einfache Weise die Gewinnung eines Impulsfrequenzsignals mit einer hohen Amplitude am Ausgang erzielt, das sich durch eine hohe Störsicherheit auszeichnet, mit hoher Genauigkeit gemessen wird, keine Analog-Digital-Umsetzung bei der Anpassung an einen Computer erfordert.

Das Verhältnis der Beimischungskonzentrationen in der Halbleiterstruktur, bei dem die Anzahl der durch die Beimischung des ersten Leitfähigkeitstyps erzeugten, durch die dritte Beimischung kompensierten Ladungsträger die Anzahl der durch die Beimischung des zweiten Leitfähigkeitstyps erzeugten Ladungsträger um maximal eine Grössenordnung übertrifft, sorgt für die Entstehung periodischer Änderungen der Leitfähigkeit beim Stromkanal unter dem Einfluss der äusseren Einwirkung und für die Steuerung der Frequenz dieser Änderungen durch diese oder eine andere Einwirkung. Derartige Halbleiterstrukturen weisen die gleichen Vorteile, wie auch die oben beschriebenen Strukturen auf.

Der Einsatz von mit einer den n-Leitfähigkeitstyp erzeugenden Phosphorbeimischung, einer die Phosphorbeimischung kompensierenden Gold- oder Zinkbeimischung dotiertem Silizium als Material der Halbleiterstruktur sorgt für die Erzeugung von die obengenannten Vorteile realisierenden Halbleiterstrukturen.

Die gestellte Aufgabe wird auch dadurch gelöst, dass in einem Steuerverfahren für die Leitung einer aus einem mit der Beimischung des einen Leitfähigkeitstyps dotierten Werkstoff hergestellten Halbleiterstruktur, in der ein p-n Übergang durch Einlegieren der Beimischung des entgegengesetzten Leitfähigkeitstyps erzeugt ist, wobei die Beimischung des ersten Leitfähigkeitstyps durch Einlegieren einer dritten, tiefliegende Energieniveaus in der Struktur bildenden Beimischung kompensiert ist, darin bestehend, dass in der Halbleiterstruktur ein Stromkanal zwangsweise gebildet wird, gemäss der Erfindung in der Halbleiterstruktur ein derartiges Verhältnis der Beimischungskonzentrationen gesichert wird, bei dem die Anzahl der durch die Beimischung des ersten Leitfähigkeitstyps erzeugten, durch die dritte Beimischung kompensierten Ladungsträger im wesentlichen gleich der Anzahl der durch die Beimischung des zweiten Leitfähigkeitstyps erzeugten Ladungsträger ist, der Stromwert bei der Stromkanalbildung in einem Bereich eingestellt wird, bei dem in der Halbleiterstruktur eine periodische Änderung der Leitfähigkeit in der Stromkanalzone entsteht, die eine Änderung der Leitfähigkeit der gesamten Halbleiterstruktur bewirkt, und am Ausgang der Halbleiterstruktur eine Impulsfolge erzeugt wird.

Es ist zweckmässig, die Frequenz der Änderung der Leitfähigkeit in der Stromkanalzone durch mindestens eine äussere Einwirkung zu steuern.

Die gestellte Aufgabe wird ferner dadurch gelöst, dass im Steuerverfahren für die Leitung einer aus einem mit der Beimischung des einen Leitfähigkeitstyps dotierten Werkstoff hergestellten Halbleiterstruktur, in der ein p-n Übergang durch Einlegieren der Beimischung des entgegengesetzten Leitungstyps erzeugt ist, wobei die Beimischung des ersten Leitfähigkeitstyps durch Einlegieren einer dritten Beimischung kompensiert ist, die in der Struktur tiefliegende Energieniveaus bildet, darin bestehend, dass in der Halbleiterstruktur ein Stromkanal zwangsweise gebildet und auf die Halbleiterstruktur von aussen eingewirkt wird, gemäss der Erfindung in der Halbleiterstruktur für ein solches Verhältnis der Beimischungskonzentrationen gesorgt wird, bei dem die Anzahl der durch die Beimischung des ersten Leitfähigkeitstyps erzeugten, durch die dritte Beimischung kompensierten Ladungsträger die Anzahl der durch die Beimischung des zweiten Leitfähigkeitstyps erzeugten Ladungsträger um maximal eine Grössenordnung überschreitet, der Stromwert bei der Stromkanalbildung in einem Bereich eingestellt wird, bei dem in der Halbleiterstruktur bei den äusseren Einwirkungen eine periodische Änderung der Leitfähigkeit in der Stromkanalzone entsteht, die eine Änderung der Leitfähigkeit in der gesamten Halbleiterstruktur bewirkt, und am Ausgang der Halbleiterstruktur eine Impulsfolge erzeugt wird, deren Wiederholungsfrequenz von der Grösse der äusseren Einwirkung abhängt.

Es ist vorteilhaft, den Strombereich, bei dem in der Struktur die periodische Änderung der Leitfähigkeit in der Stromkanalzone entsteht, in Abhängigkeit von den Konzentrationen sämtlicher Beimischungstypen, den geometrischen Abmessungen und Konstruktionsparametern der Halbleiterstruktur zu wählen.

Es ist möglich, als äussere Einwirkung ein Magnetfeld anzuwenden, das senkrecht zum Stromkanal in der Struktur gerichtet ist.

Möglich ist es auch, als äussere Einwirkung eine mechanische Kraft zu benutzen und sie an die Halbleiterstruktur im Bereich der Eingrenzung des Stromkanals anzulegen.

In manchen Fällen ist es erwünscht, als äussere Einwirkung eine Lichtstrahlung zu benutzen und sie in den Bereich der Eingrenzung des Stromkanals zu lenken.

Es ist auch möglich, bei der Benutzung der Halbleiterstruktur mit einem Verhältnis der Beimischungskonzentrationen derart, daß die Anzahl der durch die Beimischung des ersten Leitfähigkeitstyps erzeugten, durch die dritte Beimischung kompensierten Ladungsträger im wesentlichen gleich der Anzahl der durch die Beimischung des zweiten Leitfähigkeitstyps erzeugten Ladungsträger ist, als äussere Einwirkung eine Wärmeeinwirkung zu verwenden.

Zweckmässig ist es auch, bei der Benutzung der Halbleiterstruktur mit einem Verhältnis der Beimischungskonzentrationen derart, daß die Anzahl der durch die Beimischung des ersten Leitfähigkeitstyps erzeugten Ladungsträger die Anzahl der durch die Beimischung des zweiten Leitfähigkeitstyps erzeugten Ladungsträger um maximal eine Grössenordnung übertrifft, als äussere Einwirkung mindestens zwei Arten der äusseren Einwirkung auszunutzen, wobei die äussere Einwirkung der einen Art die periodische Änderung der Leitfähigkeit in der Stromkanalzone zu veranlassen hat und die äusseren Einwirkungen der anderen Arten die Frequenz dieser Änderung zu steuern haben.

Möglich ist, als mindestens zwei Arten der äusseren Einwirkungen ein magnetisches Feld, eine mechanische Kraft, eine Lichtstrahlung zu verwenden.

Die Steuerung der Frequenz der periodischen Änderungen der Leitfähigkeit der Halbleiterstruktur durch die äussere Einwirkung (Magnetfeld, mechanische Kraft, Lichtstrahlung, Wärmewirkung) gestattet es, nach der Frequenz dieser Änderungen die Grösse der ausgeübten Einwirkung zu bestimmen. Da aber das Informationssignal hierbei von der Art eines Impulsfrequenzsignals ist, werden die Störsicherheit und die Messgenauigkeit beträchtlich erhöht, die Anpassung an einen Computer vereinfacht (es entfällt ein Analog-Digital-Wandler).

Die Benutzung von mindestens zwei Arten der äusseren Einwirkungen als äussere Einwirkung, bei denen die eine eine periodische Änderung der Leitfähigkeit in der Stromkanalzone veranlasst und die andere die Frequenz dieser Änderung steuert, erlaubt es, den Schwellenwert der äusseren Einwirkungen wesentlich herabzusetzen, bei dem die periodische Änderung der Leitfähigkeit entsteht, und die Messbereiche zu erweitern.

Die gestellte Aufgabe wird auch dadurch gelöst, dass ein Fühlelement auf der Basis einer aus einem mit     der Beimischung des einen Leitfähigkeitstyps dotierten Werkstoff hergestellten Halb-_ leiterstruktur, in der ein p-n Übergang durch Einlegieren der Beimischung des entgegengesetzten Leitfähigkeitstyps erzeugt ist, wobei die Beimischung des ersten Leitfähigkeitstyps durch Einlegieren einer dritten Beimischung kompensiert ist, die in der Halbleiterstruktur tiefgehende Energieniveaus bildet, das Kontakte zum p- und n-Bereich für den Anschluss an eine Speisequelle und für die Abnahme eines Ausgangssignals enthält, gemäss der Erfindung auf der Basis einer solchen Halbleiterstruktur hergestellt wird, in der das Verhältnis der Beimischungskonzentrationen so ist, dass die Anzahl der durch die Beimischung des ersten Leitfähigkeitstyps erzeugten Ladungsträger, die durch die dritte Beimischung kompensiert ist, im wesentlichen der Anzahl der durch die Beimischung des zweiten Leitungstyps erzeugten Ladungsträger gleich ist.

Die gestellte Aufgabe wird auch dadurch gelöst, dass ein Fühlelement auf der Basis einer aus einem mit der Beimischung des einen Leitungstyps dotierten Werkstoff hergestellten Halbleiterstruktur, in der ein p-n Übergang durch Einlegieren der Beimischung des entgegengesetzten Leitfähigkeitstyps erzeugt ist, wobei die Beimischung des ersten Leitfähigkeitstyps durch Einlegieren einer dritten Beimischung kompensiert ist, die in der Halbleiterstruktur tiefliegende Energieniveaus bildet, das Kontakte zum p- und n-Bereich für den Anschluss an eine Speisequelle und für die Abnahme eines Ausgangssignals enthält, gemäss der Erfindung auf der Basis einer solchen Halbleiterstruktur hergestellt wird, in der sich die Beimischungskonzentrationen in einem solchen Verhältnis befinden, dass die Anzahl der durch die Beimischung des ersten Leitfähigkeitstyps erzeugten Ladungsträger, die durch die dritte Beimischung kompensiert ist, die Anzahl der durch die Beimischung des zweiten Leitfähigkeitstyps erzeugten Ladungsträger um maximal eine Grössenordnung übertrifft.

Die Herstellung der Fühlelemente auf der Basis der Halbleiterstrukturen, in denen sich die Beimischungskonzentrationen in einem solchen Verhältnis befinden, dass die Anzahl der durch die Beimischung des ersten Leitfähigkeitstyps erzeugten, durch die dritte Beimischung kompensierten Ladungsträger der Anzahl der durch die Beimischung des zweiten Leitfähigkeitstyps erzeugten Ladungsträger im wesentlichen gleich ist oder diese um maximal eine Grössenordnung überschreitet, gestattet es, ein Ausgangs-Impulsfrequenzsignal mit einer hohen Amplitude zu erzeugen und die Frequenz dieses Signals durch äussere Einwirkungen zu steuern.

Die Frequenz des Ausgangssignals wird durch die Grösse der äusseren Einwirkung bestimmt und kann ohne Signal-Vorverarbeitung leicht gemessen werden, wodurch sich Geber für verschiedene Grössen auf der Basis derartiger Fühlelemente leicht realisieren lassen, es werden deren Genauigkeit und Störsicherheit erhöht.

Kurze Beschreibung der Zeichnungen

Die Erfindung soll nachstehend an Ausführungsbeispielen unter Bezugnahme auf die beiliegenden Zeichnungen näher erläutert werden.

Es zeigt:

Fig. 1     eine erfindungsgemässe Halbleiterstruktur;

Fig. 2    das Schaltbild der Halbleiterstruktur;

Fig. 3    die Stromspannungskennlinie von Halbleiterstrukturen;

Fig. 4    die Angriffsrichtung eines Magnetfeldes an einer Halbleiterstruktur;

Fig. 5    die Angriffsrichtung einer mechanischen Kraft an einer Halbleiterstruktur;

Fig. 6    die Angriffsrichtung einer Lichtstrahlung an einer Halbleiterstruktur;

Die besten Ausführungsformen der Erfindung

Die erfindungsgemässe Halbleiterstruktur wird aus einem mit der Beimischung eines Leitfähigkeitstyps dotierten Werkstoff hergestellt. Dann wird in die Struktur die Beimischung des entgegengesetzten Leitfähigkeitstyps zugeführt und in dieser ein p-n Übergang erzeugt. Die Beimischung des ersten Leitfähigkeitstyps wird durch Einlegieren einer dritten Beimischung kompensiert, die in der Struktur tiefliegende Energieniveaus bildet. Die Beimischungskonzentrationen befinden sich in einem solchen Verhältnis zueinander, dass die Anzahl der durch die Beimischung des ersten Leitfähigkeitstyps erzeugten, durch die dritte Beimischung kompensierten Ladungsträger der Anzahl der durch die Beimischung des zweiten Leitfähigkeitstyps erzeugten Ladungsträger im wesentlichen gleich ist oder diese um maximal eine Grössenordnung übertrifft.

Betrachten wir ein Steuerverfahren für die Leitung einer erfindungsgemässen Halbleiterstruktur, bei der die Anzahl der durch die Beimischung des ersten Leitfähigkeitstyps erzeugten, durch die dritte Beimischung kompensierten Ladungsträger im wesentlichen gleich der Anzahl der durch die Beimischung des zweiten Leitungstyps erzeugten Ladungsträger ist. In diesem Fall wird der Stromwert in der Struktur bei der Stromkanalbildung in einem Bereich eingestellt, bei dem in der Struktur eine periodische Änderung der Leitfähigkeit in der Stromkanalzone entsteht. Dies bewirkt eine Änderung der Leitfähigkeit in der gesamten Struktur. Hierbei tritt am Ausgang der Halbleiterstruktur eine Impulsfolge auf.

Gehen wir auf ein Steuerverfahren für die Leitung einer Halbleiterstruktur ein, in der eine periodische Änderung der Leitfähigkeit hervorgerufen ist. Auf eine derartige Struktur wird mindestens eine äussere Einwirkung ausgeübt, mit deren Hilfe die Frequenz der Leitfähigkeitsänderung und folglich die Frequenz der Impulsfolge am Ausgang der Halbleiterstruktur gesteuert wird.

Es sei auf ein Steuerverfahren für die Leitung einer Halbleiterstruktur eingegangen, bei der die Anzahl der durch die Beimischung des ersten Leitfähigkeitstyps erzeugten, durch eine dritte Beimischung kompensierten Ladungsträger die Anzahl der durch die Beimischung des zweiten Leitungstyps erzeugten Ladungsträger um nicht mehr als eine Grössenordnung überschreitet. In diesem Fall wird auf die Halbleiterstruktur von aussen eingewirkt, und der Strom wird in einem Bereich eingestellt, bei dem im Falle der äusseren Einwirkung eine periodische Änderung der Leitfähigkeit in der Stromkanalzone der Struktur auftritt (Beim Fehlen der äusseren Einwirkungen findet in einer derartigen Halbleiterstruktur keine Änderung der Leitfähigkeit statt). Hierbei wird am Ausgang der Halbleiterstruktur eine Impulsfolge erzeugt, deren Wiederholungsfrequenz von der Grösse der äusseren Einwirkung abhängt. Der Strombereich, bei dem in den betrachteten Strukturen eine periodische Änderung der Leitfähigkeit in der Stromkanalzone auftritt, wird in Abhängigkeit von den Konzentrationen sämtlicher Beimischungstypen, den geometrischen Abmessungen und den Konstruktionsparametern der Struktur gewählt.

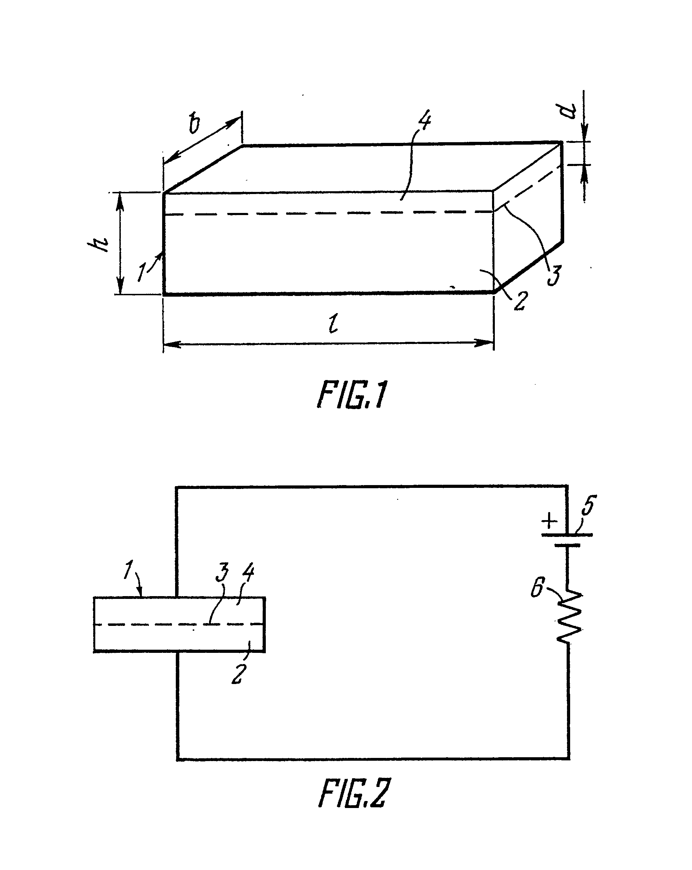

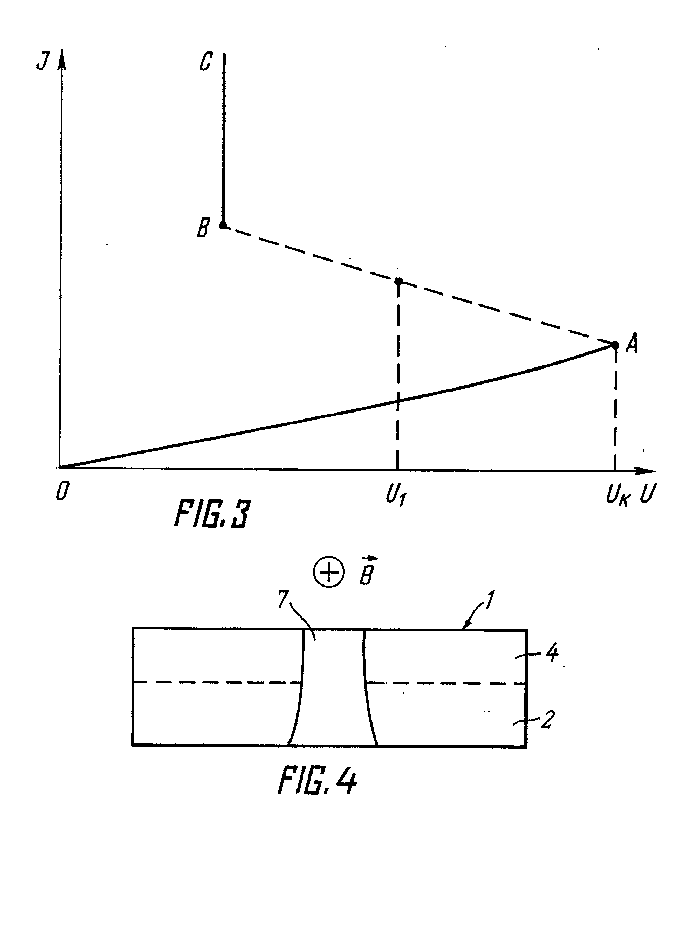

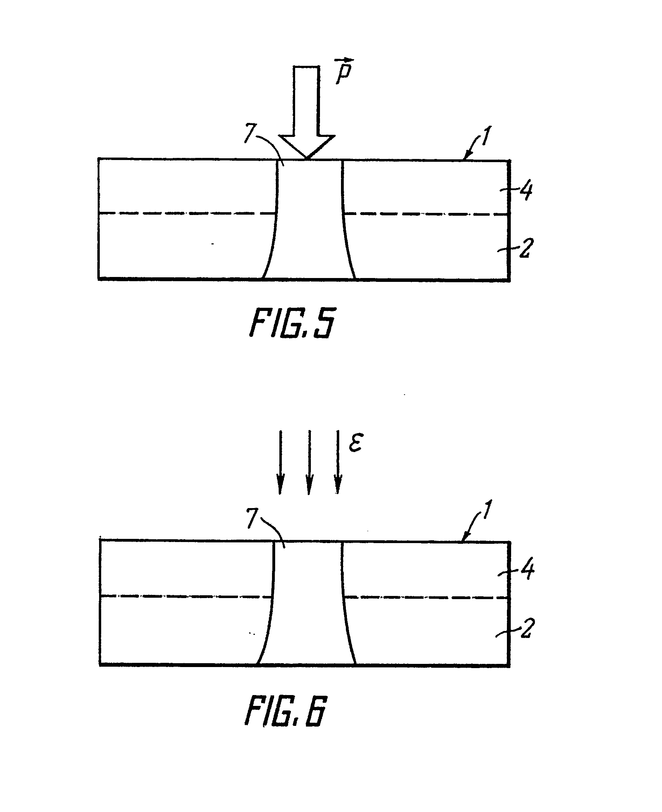

Die physikalischen Prozesse, die in der Halbleiterstruktur ablaufen, werden am Beispiel einer konkreten Halbleiterstruktur (Fig. 1) betrachtet.

Die Halbleiterstruktur 1 wird aus Silizium hergestellt, das mit Phosphor dotiert wird. Der Phosphor stellt im Silizium eine Donatorbeimischung dar und erzeugt einen n-Leitfähigkeitstyp (n-Bereich 2). Die Majoritätsladungsträger sind im n-Bereich 2 der Struktur 1 Elektronen, deren Konzentration durch die Konzentration $N_P$ der Phosphordotierung bestimmt wird. Zur Erzeugung eines p-n Überganges 3 mit einer Einlagerungstiefe d wird in die Struktur 1 Aluminium zugeführt. Das Aluminium stellt im Silizium eine Akzeptorbeimischung dar und erzeugt einen p-Leitfähigkeitstyp (p--Bereich 4). Die Majoritätsladungsträger sind im p-Bereich 4 der Struktur 1 Löcher, deren Konzentration durch die Aluminiumkonzentration $N_{Al}$ festgelegt wird. Die Phosphordotierung wird durch tiefe Beimischung - Gold- mit der Goldkonzentration $N_{Au}$ vollständig kompensiert, wobei die Elektronen auf die tiefliegenden Gold-Energieniveaus übergehen und deren Konzentration im n-Bereich 2 praktisch auf den Wert der Ladungsträgerinversionsdichte im Silizium abfällt.

Die Abmessungen der Struktur 1 sind: Länge l, Breite b, Höhe (Dicke) h.

Im Ausgangszustand kann bei einer sich von der Temperatur des absoluten Nullpunkts unterscheidenden Temperatur angenommen werden, dass die Majoritätsladungsträgerkonzentration - Löcherkonzentration - im p-Bereich 4 die Majoritätsladungsträgerkonzentration-Elektronenkonzentration - im n-Bereich 2 um Vieles überschreitet, weil sich die Elektronen im wesentlichen auf den tiefliegenden Gold-Energieniveaus befinden. Der Widerstand der Struktur 1 wird hauptsächlich durch den Widerstand des kompensierten n-Bereichs 2 bestimmt, dessen Leitfähigkeit nahe der Eigenleitung ist.

Betrachten wir die Stromspannungskennlinie der Struktur 1 bei der Durchlassvorspannung des p-n Überganges 3 (der p-Bereich 4 wird an die Plusklemme einer Gleichspannungsquelle 5 (Fig. 2) gelegt).

Die Struktur 1 wird in den Stromkreis der Gleichspannungsquelle 5 über einen Lastwiderstand 6 geschaltet, der zur Begrenzung des Stroms und zur Abnahme des Ausgangssignals dient.

Im Anfangsbereich der Stromspannungskennlinie (Fig. 3, Abschnitt OA) ist der Widerstand der Struktur 1 gross und der Strom durch die Struktur 1 klein. Mit steigender Speisespannung wächst der Strom monoton an. Die an die Struktur 1 (Fig. 2) angelegte Spannung fällt im wesentlichen im hochohmigen n-Bereich 2 ab. Zu einem bestimmten Zeitpunkt erreicht die Spannung einen kritischen Wert $U_k$ (Fig. 3), bei dem die elektrische Feldstärke in der Struktur 1 auf einen Wert ansteigt, der der Aktivierungsenergie von Ladungsträgern (Elektronen) entspricht, die sich auf den Niveaus der kompensierenden Beimischung befinden. Angesichts dessen, dass es in der Struktur 1 (Fig. 2) wegen der Ungleichmässigkeit der Verteilung der Dotierungsstoffe, des Vorhandenseins von Baufehlern und Versetzungen stets Abschnitte gibt, auf denen eine energetische Erwärmung der Ladungsträger infolge des Anstiegs der Feldstärke bei geringeren Spannungswerten $U_k$ (Fig. 3) als im restlichen Volumen erreicht wird, erfolgt ein lokaler "Durchbruch" der Struktur 1 (Fig. 2). Es entsteht also ein Abschnitt, auf dem die auf einem tiefliegenden Kompensations-Energieniveau befindlichen Ladungsträger in die Leitungszone übergehen. Hierbei findet ein steiler Anstieg der Leitfähigkeit des betreffenden Abschnitts statt. Es wird mit der Stromkanalbildung begonnen. In der Struktur 1 wird der Gleichgewichtszustand gestört, es entsteht ein Elektronendichtegradient, zu dessen Beseitigung sich ein Löcherdiffusionsstrom richtet. Die Weiterentwicklung des Vorganges wird durch das Verhältnis der Beimischungen in der Struktur 1 bestimmt, und hier sind drei Fälle möglich.

1. Ist die Anzahl der Ladungsträger (Elektronen), die durch Einlegieren der Phosphorbeimischung erzeugt und durch die Goldbeimischung kompensiert sind (beim "Durchbruch" werden die Elektronen in der Stromkanalbildungszone von den tiefliegenden Goldniveaus freigesetzt), kleiner, als die Anzahl der durch die Aluminiumbeimischung erzeugten Ladungsträger (Löcher), so rekombinieren die die Goldniveaus verlassenden Elektronen beim Erreichen der Spannung $U_k$ an der Struktur 1 rasch mit den Löchern. Es entsteht kein Stromkanal.

2. Ist die Anzahl der Ladungsträger, die durch den Einlegieren der Phsophorbeimischung erzeugt und durch die Goldbeimischung kompensiert sind, erfindungsgemäss im wesentlichen gleich der Anzahl der durch die Aluminiumbeimischung erzeugten Ladungsträger, so wird der in der Struktur 1 begonnene Vorgang der Stromkanalbildung beim Erreichen der Spannung $U_k$ an der Struktur 1 fortgesetzt. Nach Abschluss dieses Prozesses steigt der Strom durch die Struktur 1 an, die Spannung an der Struktur 1 (Fig. 3, Abschnitt BC) fällt ab. Hierbei ist die Stromdichte im Schnitt der Struktur 1 (Fig. 2) ungleich: in der Stromkanalzone ist sie viel grösser, als in den anderen Querschnitten. Die an die Stromkanalgrenzen herankommenden Löcher rekombinieren mit den Ladungsträgern (Elektronen) im Stromkanal.

Die Weiterentwicklung des Prozesses wird durch die Stärke des Kanalstroms bestimmt, die vom Wert des Lastwiderstandes 6 (Fig. 2), der Speisespannung, der Konzentration sämtlicher Beimischungstypen, den geometrischen Abmessungen und den Konstruktionsparametern der Struktur 1 abhängt. Je kleiner der Wert des Lastwiderstandes 6 und je höher die Speisespannung ist, desto stärker ist der Kanalstrom. Je höher die Beimischungsdichte liegt, um so höher ist die Kanalstromdichte. Mit steigender Höhe h nimmt der Kanaldurchmesser und folglich der Strom zu. In Abhängigkeit vom Kanalstrom, d.h. von der Kanalstromdichte und dem Kanaldurchmesser veranlasst also der Rekombinationsvorgang an den Kanalgrenzen folgendes.

In einem gewissen Strombereich, der von dem durch die Struktur bei der Spannung $U_k$ fliessenden Strom geringfügig abweicht, ist die Anzahl der an die Kanalgrenzen herankommenden Löcher, die im wesentlichen der Anzahl der Elektronen gleich ist, ausreichend, um den Vorgang einer Zerstörung des Stromkanals einzuleiten. Der Kanalstrom nimmt ab, die Spannung an der Struktur 1 nimmt zu. Bei einem Spannungsanstieg an der Struktur 1 auf einen Wert $U_1$ (Fig. 3) es nimmt dementsprechend auch die elektrische Feldstärke zu) werden die rekombinierten Elektronen durch das Feld wieder aktiviert, es beginnt ein neuer Vorgang der Stossionisation, und der Stromkanal erweitert sich auf den ursprünglichen Wert. In der Halbleiterstruktur 1 (Fig. 1,2) mit dem genannten Beimischungsverhältnis entsteht also im genannten Strombereich beim Erreichen des bestimmten Spannungswertes $U_k$ (Fig. 3) eine periodische Änderung der Leitfähigkeit in der Stromkanalzone. Bei der Stromzunahme im vorgegebenen Bereich verlängert sich die Zeit der Zerstörung des Stromkanals und folglich vergrössert sich die Frequenz der Leitfähigkeitsänderung der Halbleiterstruktur 1 (Fig. 2). Bei einem weiteren Stromanstieg (über den für die jeweilige Probe vorgegebenen Bereich) reichen die an die Kanalgrenzen herankommenden Löcher nicht mehr aus, um den Stromkanal zu zerstören, und es tritt keine periodische Änderung der Leitfähigkeit bei der Halbleiterstruktur 1 auf, es bildet sich also ein beständiger Stromkanal.

3. Ist die Anzahl der durch Einlegieren der Goldbeimischung erzeugten Ladungsträger (Elektronen) grösser, als die Anzahl der durch die Aluminiumbeimischung erzeugten Ladungsträger (Löcher), so reichen die Löcher nicht aus, um den Stromkanal zu zerstören, und dann wird in der Struktur 1 (Fig. 2) ein Stromkanal gebildet, der sich beim Ausbleiben der äusseren Einwirkungen in einem stabilen Zustand befindet.

Betrachten wir die Struktur 1 (Fig. 4), in der periodische Änderungen der Leitfähigkeit in der Zone des Stromkanals 7 entstanden sind. Beim Anlegen eines Magnetfeldes an eine derartige Struktur 1, welches senkrecht zum Stromkanal 7 gerichtet ist, wirkt auf die Ladungsträger (Elektronen und Löcher) im Kanal 7 und ausserhalb des Kanals 7 eine Lorentz-Kraft $F_L$ (Fig. 4) ein. Unter der Wirkung dieser Kraft werden die Ladungsträger von der ursprünglichen Bewegungsrichtung abgelenkt. Da hierbei die Beweglichkeit der Elektronen höher, als die der Löcher ist, so werden die ersteren um einen grösseren Wert abgelenkt. Dies führt dazu, dass im Bereich des Stromkanals 7 das Gleichgewicht zwischen den Löchern und den Elektronen gestört wird, es kommt zu mehr Löchern, und der Stromkanal 7 wird schneller zerstört.

Der Widerstand der Struktur 1 nimmt zu, die Spannung an der Struktur wächst an. Beim Erreichen des Wertes $U_1$ (Fig. 3) durch die Spannung an der Struktur 1 findet der nächste Vorgang der Aktivierung von Elektronen statt, die auf die tiefliegenden Gold-Energieniveaus zurückgekehrt sind, und der Vorgang wiederholt sich. Das angelegte Magnetfeld vergrössert also die Geschwindigkeit der Zerstörung des Stromkanals 7 (Fig. 4), wodurch die Frequenz der Leitfähigkeitsänderung bei der Halbleiterstruktur 1 vergrössert wird. Am Ausgang der Struktur 1 wird ein Impulsfrequenzsignal erzeugt, dessen Frequenz der magnetischen Feldstärke direkt proportional ist.

Wird an die Struktur 1 (Fig. 5), bei der die Änderungen der Leitfähigkeit in der Zone des Stromkanals 7 aufgetreten sind, im Bereich der Eingrenzung des Stromkanals 7 eine mechanische Kraft P als äussere Einwirkung angelegt, so führt dies zu einer Energiebandkrümmung. Die Aktivierungsenergien der tiefliegenden energiereichen Goldbeimischung werden in der Mitte des Stromkanals 7 und an den Kanalgrenzen verschieden sein. In der Mitte des Stromkanals 7 werden die Aktivierungsenergien ab- und an den Grenzen zunehmen. Dies hat zur Folge, dass ein Teil der freien Elektronen sich an den Grenzen des Kanals 7 auf den Goldniveaus "absetzt". Die Rekombinationsgeschwindigkeit wird sich auch ändern. Hierbei wird sich also die Frequenz der Leitfähigkeitsänderung bei der Struktur 1 von der ursprünglichen unterscheiden, und am Ausgang der Struktur 1 wird die Signalfrequenz durch die Grösse der äusseren mechanischen Kraft P bestimmt werden.

Wird die Struktur 1 mit der periodischen Änderung der Leitfähigkeit in der Stromkanalzone einer Lichtwirkung (äussere Einwirkung) (Fig. 6) ausgesetzt, die in den Bereich der Eingrenzung des Stromkanals 7 gerichtet ist, so führt dies zu einer Änderung der Ladungsträgerkonzentration in diesem Bereich. Hierbei ändern sich die Geschwindigkeit der Zerstörung des Stromkanals 7, die Geschwindigkeit der Änderung der Leitfähigkeit und also die Frequenz des Ausgangssignals proportional zur Strahlungsintensität $\epsilon$.

Wird die Struktur 1 mit den periodischen Änderungen der Leitfähigkeit in der Stromkanalzone einer Wärmeeinwirkung (äussere Einwirkung) unterzogen, so führt dies zu einem Energiezuwachs sowohl bei den freien, als auch bei den auf den Beimischungsniveaus und im Valenzband befindlichen Ladungsträgern. Hierbei wird ein Teil der auf den tiefliegenden Gold-Energieniveaus ausserhalb des Stromkanals befindlichen Elektronen in das Leitungsband übergehen und den Strom im Kanal vergrössern (es erfolgt eine Kanalerweiterung). Je stärker hierbei die Wärmeeinwirkung ist, desto grösser ist die Kanalerweiterung. Dies hat zur Folge, dass sich die Zeit des Rekombinationsvorganges an den Kanalgrenzen verlängert. Die Geschwindigkeit der Änderung der Leitfähigkeit und folglich auch die Frequenz des Ausgangssignals nehmen proportional zur Grösse der Wärmeeinwirkung ab.

Sind also die Beimischungskonzentrationen in der beschriebenen Struktur 1 ausgehend von der Bedingung im wesentlichen einer Gleichneit der Anzahl der durch die Phosphorbeimischung erzeugten und durch die Goldbeimischung kompensierten Ladungsträger und der durch die Aluminiumbeimischung erzeugten Ladungsträger gewählt, entsteht in dieser ein stabil oszillierender Stromkanal 7, dessen Leitfähigkeit sich periodisch ändert. Hierbei kann die Frequenz der Letifähigkeitsänderung durch mindestens eine äussere Einwirkung auf die Struktur durch Anlegen eines Magnetfeldes, einer mechanischen Kraft, durch eine Lichtstrahlung, Wärmeeinwirkung gesteuert werden.

Auf der Basis einer derartigen Struktur 1 werden Fühlelemente realisiert, die an die Gleichspannungsquelle 5 (Fig. 2) durch einen Lastwiderstand 6 mittels Kontakte zum p- und n-Bereich 4 bzw. 2 der Halbleiterstruktur 1 angeschlossen werden. Sämtliche in einem derartigen Fühlelement ablaufenden Vorgänge und dessen Arbeitsweise sind ähnlich den Vorgängen in der Halbleiterstruktur 1 und ihrer Arbeitsweise, die oben beschrieben sind.

Betrachten wir eine Struktur 1, in der die Anzahl der durch eine Phosphorbeimischung erzeugten und durch eine Goldbeimischung kompensierten Ladungsträger die Anzahl der durch die Aluminiumbeimischung erzeugten Ladungsträger nicht mehr als um eine Grössenordnung überschreitet. In einer derartigen Struktur 1 entsteht beim Anlegen einer Spannung $U_k$ an diese ein stabiler Stromkanal 7 (Fig. 4), wie oben angegeben.

Beim Anlegen eines senkrecht zum Stromkanal 7 gerichteten Magnetfeldes an eine solche Struktur 1 werden die Ladungsträger wie im oben betrachteten Beispiel der Durchführung des Steuerverfahrens für die Leitung der Halbleiterstruktur 1 von der ursprünglichen Driftrichtung durch das Magnetfeld abgelenkt. Je stärker hierbei das Magnetfeld ist, desto grösser ist die Ablenkung der Ladungsträger. Im Stromkanal 7 wird der Rekombinationsvorgang verstärkt. Wenn sich der Strom des Kanals 7, der, wie oben angegeben, vom Wert des Lastwiderstandes 6 (Fig. 2), der Speisespannung, der Konzentration sämtlicher Beimischungstypen, den geometrischen Abmessungen und den Konstruktionsparametern der Struktur 1 abhängt, in einem Bereich bewegt, in dem bei einer gegebenen Grösse $B_1$ der magnetischen Feldstärke die Anzahl der an den Stromkanal 7 (Fig. 4) herangekommenen Löcher gleich der Anzahl der Elektronen in diesem wird, also eine Voraussetzung für im wesentlichen eine Gleichheit der Ladungsträgerzahlen geschaffen wird, so beginnt sich der Stromkanal 7 zu zerstören, und es entsteht ein Vorgang, der dem Vorgang in der oben beschriebenen Struktur 1 analog ist. Mit anderen Worten entsteht unter der Wirkung des Magnetfeldes eine periodische Änderung der Leitfähigkeit in der Zone des Stromkanals 7 der Halbleiterstruktur 1, die zu einer periodischen Änderung ihrer Leitfähigkeit und zum Auftreten eines Impulsfrequenzsignals am Ausgang führt, dessen Frequenz proportional der magnetischen Feldstärke ist. Die Grösse $B_1$ der magnetischen Feldstärke, bei der eine periodische Änderung der Leitfähigkeit in der Zone des Stromkanals 7 entsteht, hängt davon ab, um wie viel die Anzahl der von den tiefliegenden Gold-Energieniveaus aktivierten Elektronen die Anzahl der an der Rekombination beteiligten Löcher übersteigt, sowie vom Strom des Kanals 7 ab. Je mehr Elektronen sind, um so höher ist die Grösse $B_1$. Wenn aber die Elektronenzahl die Löcherzahl um mehr als eine Grössenordnung übertrifft, so wird die Wirkung des Magnetfeldes unzureichend sein, um in der Struktur 1 Bedingungen für im wesentlichen eine Gleichheit der Trägerzahlen zu schaffen, es wird keine periodische Änderung der Leitfähigkeit in der Zone des Stromkanals 7 auftreten. Zum gleichen Ergebnis wird der Stromanstieg auf einen Wert führen, der oberhalb des für die jeweilige Struktur 1 festgelegten Bereichs liegt.

Wird nun an diese Struktur 1 eine mechanische Kraft (äussere Einwirkung) im Bereich der Eingrenzung des Stromkanals 7, wie in Fig. 5 gezeigt, angelegt und der Strom im obengenannten Bereich eingestellt, so werden die Aktivierungsenergien der tiefliegenden energetischen Goldbeimischung in der Mitte des Stromkanals 7 und an seinen Grenzen infolge einer Energiebandkrümmung verschieden sein. In der Mitte des Stromkanals 7 werden die Aktivierungsenergien ab- und an seinen Grenzen zunehmen. Dies führt dazu, dass sich ein Teil der freien Elektronen an den Grenzen des Kanals 7 auf den Goldniveaus "absetzt".

Je stärker die mechanische Kraft ist, um so höher ist die Anzahl derartiger Elektronen. Hat die mechanische Kraft eine Grösse, bei der die Elektronenzahl gleich der Löcherzahl ist, so setzt an den Grenzen des Stromkanals 7 der Vorgang einer Leitfähigkeitsabnahme ein, und es entstehen Schwankungen der Leitfähigkeit in der Zone des Stromkanals 7 der Struktur 1, die den oben beschriebenen ähnlich sind. Die Schwingungsfrequenz und folglich auch die Ausgangssignalfrequenz sind proportional der Grösse der anzulegenden mechanischen Kraft.

Betrachten wir noch eine Variante der äusseren Einwirkung auf eine derartige Struktur, als welche eine Lichtstrahlung ausgenutzt wird. Die Einwirkung der in den Bereich der Eingrenzung des Stromkanals (Fig. 6) gerichteten Lichtstrahlung auf die Halbleiterstruktur, deren Intensität $\epsilon$ zur Überführung der Elektronen vom Valenzband auf die tiefliegenden Gold-Energieniveaus ausreicht, führt zu einer Vergrösserung der Löcherkonzentration in der Stromkanalzone. Sobald die Zahl dieser Löcher der Elektronenzahl gleich ist, d.h. die Bedingung für im wesentlichen eine Gleichheit der Ladungsträgerzahlen erfüllt wird, entstehen in der Struktur 1 periodische Änderungen der Leitfähigkeit in der Stromkanalzone. Je höher die Lichtstrahlungsintensität $\epsilon$ ist, um so schneller wird sich der Kanal 7 zerstören und um so höher wird die Frequenz der periodischen Änderungen seiner Leitfähigkeit sein.

Überschreitet also die Anzahl der durch die Phosphorbeimischung erzeugten, durch die Goldbeimischung kompensierten Elektronen in der erfindungsgemässen Siliziumstruktur 1 die Anzahl der durch die Aluminiumbeimischung erzeugten Löcher um nicht mehr als eine Grössenordnung, entsteht in einer derartigen Struktur 1 unter dem Einfluss einer äusseren Einwirkung oberhalb eines bestimmten Schwellenwertes eine periodische Änderung der Leitfähigkeit in der Zone des Stromkanals 7. Am Ausgang dieser Struktur 1 wird ein Ausgangs-Impulsfrequenzsignal erzeugt, dessen Frequenz proportional der Grösse der äusseren Einwirkung ist. Der Schwellenwert der äusseren Einwirkung ist hierbei um so höher, je grösser der Unterschied zwischen den angegebenen Ladungsträgerzahlen ist.

Eine wesentliche Erniedrigung des Schwellenwertes kann durch mindestens zwei Arten der Einwirkung auf die Struktur 1 erreicht werden. In diesem Fall wird beispielsweise durch ein Magnetfeld die Entstehung der periodischen Änderungen der Leitfähigkeit in der Zone des Stromkanals 7 ausgelöst, während durch einen Druck oder eine Lichtstrahlung, deren Frequenz gesteuert wird. Es sind auch andere Kombinationen der äusseren Einwirkungen möglich.

Auf der Basis einer derartigen Struktur 1 werden Fühlelemente realisiert, die an die Gleichspannungsquelle 5 (Fig. 2) durch den Lastwiderstand 6 mittels Kontakten zum p- und n-Bereich 4 bzw. 2 der Halbleiterstruktur 1 angeschlossen werden. Sämtliche in einem solchen Fühlelement ablaufenden Vorgänge und dessen Arbeitsweise sind analog den Vorgängen in der Halbleiterstruktur 1 und ihrer Arbeitsweise, die oben beschrieben sind.

Es sei auf mehrere konkrete Ausführungsformen der Fühlelemente auf der Basis der erfindungsgemässen Halbleiterstrukturen eingegangen, die in Verfahren der Standardtechnologie für Halbleitergeräte hergestellt werden.

I. Das Fühlelement ist auf der Basis einer Halbleiterstruktur 1 hergestellt in der sich die Beimischungskonzentrationen in einem solchen Verhältnis befinden, dass die Anzahl der durch die Beimischung des ersten Leitfähigkeitstyps erzeugten, durch die dritte Beimischung kompensierten Ladungsträger im wesentlichen gleich der Anzahl der durch die Beimischung des zweiten Leitfähigkeitstyps erzeugten Ladungsträger ist.

Beispiel 1

Das Ausgangsmaterial ist Silizium, als Beimischung des ersten Leitfähigkeitstyps dient Phosphor mit einer Konzentration $N_p$ von $10^{13}$ $cm^{-3}$; als Beimischung des zweiten Leitfähigkeitstyps dient Aluminium mit einer Konzentration $N_{Al}$ von $10^{14}$ $cm^{-3}$; als dritte Beimischung dient Gold mit einer Konzentration $N_{Au}$ von $10^{13}$ $cm^{-3}$. Die Kontakte zum p- und n-Bereich 4 bzw. 2 sind sperrfrei.

Die Abmessungen des Fühlelements sind: l =

7 mm; b = 1,5 mm; h = 0,33 mm; d = 0,03 mm.

Der kritische Spannungswert $U_k \approx 15$ V.

Der Bereich $\Delta \mathfrak{I}$ des Stroms $\mathfrak{I}$, bei dem in der Halbleiterstruktur eine periodische Änderung der Leitfähigkeit entsteht, beträgt 1,7 bis 2,2 mA. Der Bereich $\Delta f$ der Frequenz f des Ausgangssignals beträgt hierbei 1,5 bis 5 kHz. Die Dauer $\tau$ der vorderen Impulsflanke beträgt ca 7 $\mu$s. Unter der Wirkung einer in die Zone des Stromkanals 7 gerichteten Lichtstrahlung kann die Frequenz f des Ausgangssignals 50 kHz erreichen.

Beispiel 2

Das Ausgangsmaterial und die Beimischungskonzentration sind analog wie im Beispiel 1.

Die Abmessungen des Fühlelements sind: l = 7 mm; b = 1,5 mm; h = 0,28 mm; d = 0,025 mm.

In diesem Fall ist $U_k \approx 7$ V; $\Delta \mathfrak{I}$ beträgt 1,4 bis 2,0 mA. $\Delta f$ beläuft sich auf 2 bis 7,5 kHz und $\tau$ auf ca. 5 $\mu$s.

Unter der Wirkung einer in die Zone des Stromkanals 7 gerichteten Lichtstrahlung kann die Frequenz f des Ausgangssignals 63 kHz erreichen.

Beispiel 3

Das Ausgangsmaterial ist Silizium; als Beimischung des ersten Leitfähigkeitstyps dient Phosphor mit einer Konzentration $N_P$ von $10^{13}$ $cm^{-3}$; als Beimischung des zweiten Leitfähigkeitstyps dient Aluminium mit einer Konzentration $N_{Al}$ von $10^{14}$ $cm^{-3}$; als dritte Beimischung dient Zink mit einer Konzentration $N_{Zn}$ von $2.10^{13}$ $cm^{-3}$.

Die Kontakte zum p- und n-Bereich sind sperrfrei.

Die Abmessungen des Fühlelements sind: l = 7 mm; b = 1,5 mm; h = 0,33 mm; d = 0,03 mm.

In diesem Fall ist $U_k \approx 16$ V, $\Delta \mathfrak{I}$ beträgt 2,1 bis 2,6 mA; $\Delta f$ beträgt 1,1 bis 4,8 kHz; $\tau$ ist ca. 9 $\mu$s gleich.

Unter der Wirkung einer in die Zone des Stromkanals 7 gerichteten Lichtstrahlung kann die Frequenz f des Ausgangssignals 43 kHz erreichen.

II. Das Fühlelement ist auf der Basis einer Halbleiterstruktur 1 hergestellt in der sich die Beimischungskonzentrationen in einem solchen Verhältnis befinden, dass die Anzahl der durch die Beimischung des ersten Leitfähigkeitstyps erzeugten, durch die dritte Beimischung kompensierten Ladungsträger die Anzahl der durch die Beimischung des zweiten Leitfähigkeitstyps erzeugten Ladungsträger nicht mehr als um eine Grössenordnung übertrifft.

Beispiel 4

Das Ausgangsmaterial ist Silizium; als Beimischung ersten Leitfähigkeitstyps dient Phosphor mit einer Konzentration $N_P$ von $10^{13}$ cm$^{-3}$; als Beimischung des zweiten Leitfähigkeitstyps dient Aluminium mit einer Konzentration $N_{Al}$ von $5.10^{13}$ cm$^{-3}$; als dritte Beimischung dient Gold mit einer Konzentration $N_{Au}$ von $10^{13}$ cm$^{-3}$.

Die Abmessungen des Fühlelements sind: l = 10 mm; b = 1,5 mm; h = 0,3 mm; d = 0,025 mm.

In diesem Fall ist $U_k \approx 10V$.

Der Strombereich $\Delta\mathcal{I}_1$, in dem unter der Wirkung des Magnetfeldes eine periodische Änderung der Leitfähigkeit bei der Struktur 1, entsteht, beträgt 1,5 bis 6 mA, $\tau$ ist ca. 8 $\mu$s gleich.

Unter der Wirkung eines senkrecht zum Stromkanal 7 gerichteten Magnetfeldes wird am Ausgang der Struktur 1 eine Impulsfolge erzeugt. Die Wiederholungsfrequenz f der Impulse beträgt im Bereich des Magnetfeldes B von 100 mT bis 600 mT (0,5 bis 20) kHz.

Beispiel 5

Das Ausgangsmaterial und die Beimischungskonzentrationen sind ähnlich wie im Beispiel 4.

Die Abmessungen des Fühlelements sind: l = 10 mm; b = 1,5 mm; h = 0,4 mm; d = 0,04 mm.

In diesem Fall ist $U_k \approx 25$ V; $\Delta\mathcal{I}_1$ beträgt 2,1 bis 8 mA, $\tau$ ist ca. 13 $\mu$s gleich.

Unter der Wirkung eines senkrecht zum Stromkanal 7 gerichteten Magnetfeldes wird am Ausgang der Struktur eine Impulsfolge erzeugt. Die Wiederholungsfrequenz f der Impulse beträgt im Bereich des Magnetfeldes B von 100 mT bis 600 mT (0,5 bis 15) kHz.

Aus den angeführten Beispielen ist es ersichtlich, dass durch Variieren der technologischen Konstruktionsparameter der Strukturen 1 die Parameter und Kennlinien der Fühlelemente und der anderen Halbleitergeräte auf der Basis derartiger Strukturen in recht weiten Grenzen gesteuert werden können. Hierbei tritt am Ausgang derartiger Bauelemente und Geräte ein stabiles Ausgangs-Impulsfrequenzsignal auf, dessen Form und Amplitude seine einfache Weiterverarbeitung ermöglichen.

Die beschriebenen Halbleiterstrukturen können als Fühlelemente von Gebern für verschiedene physikalische Grössen mit einem Ausgangs-Impulsfrequenzsignal, von Generatoren mit Selbsterregung, Schwellenwertgliedern, Gleichspannungs-Frequenz-Wandlern u.a. angewendet werden.

Beim Einsatz der Strukturen als Fühlelemente der Geber wird an die Struktur 1 von aussen eingewirkt, und nach der Frequenz der Ausgangssignals wird die Grösse dieser Einwirkung bestimmt. Wenn sich hierbei der Stromkanal beim Ausbleiben der äusseren Einwirkungen in einem stabilen Zustand befindet, d.h., wenn keine periodischen Änderungen der Leitfähigkeit in der Stromkanalzone auftreten, so muss der Minimalwert der äusseren Einwirkung oberhalb des Schwellenwertes liegen, damit die periodischen Änderungen der Leitfähigkeit entstehen. Dieser Schwellenwert ist um so höher, je mehr die Anzahl der durch die Beimischung des ersten Leitfähigkeitstyps erzeugten, durch die dritte Beimischung kompensierten Ladungsträger die Anzahl der durch die Beimischung des zweiten Leitfähigkeitstyps erzeugten Ladungsträger überschreitet. Hierbei kann die Änderung der Leitfähigkeit beim Stromkanal durch die eine Einwirkung hervorgerufen werden, während die Frequenz dieser Änderungen (d.h. die Bestimmung ihrer Grösse) durch eine andere Einwirkung gesteuert werden kann (die Einwirkungen können von der gleichen Art sein).

Der Bereich der Messungen auf der Basis der erfindungsgemässen Fühlelemente kann also weit variiert werden. Der Minimalwert der äusseren Einwirkung wird durch denjenigen Minimalwert der Frequenzänderung beim Ausgangssignal bestimmt werden, der durch die nachgeschalteten Messeinheiten festgehalten werden kann. Der Maximalwert der äusseren Einwirkung wird durch die Ladungsträgerzahl im Stromkanal bestimmt und wächst mit der Vergrösserung der letzteren an.

Die Amplitude des Ausgangs-Impulsfrequenzsignals derartiger Fühlelemente beträgt mehrere Volt und seine Frequenz mehrere hundert Hz bis mehrere hundert kHz.

Der Impulsfrequenzverlauf und die hohe Ausgangssignalamplitude gewährleisten eine hohe Störsicherheit und Messgenauigkeit, bedürfen keiner speziellen Störschutzmassnahmen, keiner Signalverstärkung, vereinfachen die Anpassung an einen Computer beträchtlich (brauchen keine Analog-Digital-Umwandlung).

Halbleiterstrukturen, in denen die periodischen Änderungen der Leitfähigkeit in der Stromkanalzone beim Fehlen der äusseren Einwirkungen entstehen, können als Generatoren mit Selbsterregung eingesetzt werden. Hierbei wird die ursprüngliche Schwingungsfrequenz f durch die Ladungsträgerzahl im Stromkanal bestimmt und kann durch Änderung der Speisespannung geändert werden.

Halbleiterstrukturen, in denen die periodischen Änderungen der Leitfähigkeit im Stromkanal durch die äusseren Einwirkungen hervorgerufen werden, können als Schwellenwertglieder angewendet werden. In diesem Fall werden in Abhängigkeit von der Ladungsträgerzahl im p- und n-Gebiet und der Speisespannung bei einer äusseren Einwirkung oberhalb der vorgegebenen Schwelle entweder mit den periodischen Änderungen der Leitfähigkeit im Stromkanal zusammenhängende Stromschwankungen oder eine sprunghafte Stromverminderung aufgrund einer vollständigen Zerstörung des Stromkanals entstehen.

Beim Aufbau von Gleichspannungs-Frequenz-Wandlern auf der Basis der beschriebenen Strukturen wird zuerst die Gleichspannung in ein magnetisches Gleichfeld (mit Hilfe einer Elektromagnetspule) umgewandelt, das nachher in die Frequenz umgesetzt wird.

Ein wesentlicher Vorteil der geschilderten Einrichtungen ist die einfache Erzeugung eines Ausgangs-Impulsfrequenzsignals am Ausgang. Das Fehlen zusätzlicher Bauelemente zur Signalverstärkung, -erzeugung und -verarbeitung vereinfacht den Aufbau der Geräte auf der Basis der genannten Einrichtungen beträchtlich, verkleinert deren Abmessungen, Masse, Kosten bei gleichzeitiger Steigerung der Betriebszuverlässigkeit und Messgenauigkeit.

Industrielle Anwendbarkeit

Die Erfindung kann in der Kontrollmesstechnik, Robotertechnik, in der flexiblen automatischen Produktion angewendet werden. Auf der Grundlage der vorliegenden Erfindung können Halbleitergeber für physikalische Grössen mit einem Ausgangs-Impulsfrequenzsignal, Generatoren mit Selbsterregung, Schwellenwertglieder, Gleichspannungs-Frequenz-Wandler sowie andere Halbleitergeräte geschaffen werden, die eine einfache Erzeugung eines Ausgangs-Impulsfrequenzsignals hoher Amplitude bei einer hohen Betriebszuverlässigkeit gewährleisten.

**Patentansprüche**

1. Halbleiterstruktur, die aus einem mit der Beimischung des einen Leitfähigkeitstyps dotierten Werkstoff hergestellt und in der ein p-n Übergang (3) durch Einlegieren der Beimischung des entgegengesetzten Leitfähigkeitstyps erzeugt ist, wobei die Beimischung des ersten Leitfähigkeitstyps durch Einlegieren einer dritten Beimischung kompensiert ist, die in der Halbleiterstruktur (1) tiefliegende Energieniveaus bildet, **dadurch gekennzeichnet**, dass sich die Beimischungskonzentrationen in der Halbleiterstruktur (1) in einem solchen Verhältnis zueinander befinden, dass die Anzahl der durch die Beimischung des ersten Leitfähigkeitstyps erzeugten, durch die dritte Beimischung kompensierten Ladungsträger der Anzahl der durch die Beimischung des zweiten Leitfähigkeitstyps erzeugten Ladungsträger im wesentlichen gleich ist.

2. Halbleiterstruktur, die aus einem mit der Beimischung des einen Leitfähigkeitstyps dotierten Werkstoff hergestellt und in der ein p$^+$ -n Übergang durch Einlegieren der Beimischung des entgegengesetzten Leitungstyps erzeugt ist, wobei die Beimischung des ersten Leitfähigkeitstyps durch Einlegieren einer dritten Beimischung kompensiert sind, die in der Halbleiterstruktur (1) tiefliegende Energieniveaus bildet, **dadurch gekennzeichnet**, dass sich die Beimischungskonzentrationen in der Halbleiterstruktur (1) in einem solchen Verhältnis zueinander befinden, dass die Anzahl der durch die Beimischung des ersten Leitfähigkeitstyps erzeugten, durch die dritte Beimischung kompensierten Ladungsträger die Anzahl der durch die Beimischung des zweiten Leitfähigkeitstyps erzeugten Ladungsträger um maximal eine Grössenordnung überschreitet.

3. Halbleiterstruktur nach Anspruch 1 oder 2, **dadurch gekennzeichnet**, dass als Material der Halbleiterstruktur (1) Silizium gewählt ist, das mit einer den n-Leitfähigkeitstyp erzeugenden Beimischung dotiert ist, als welche Phosphor eingesetzt ist, und als die den p-Leitfähigkeitstyp erzeugende Beimischung Aluminium verwendet ist, wobei die den p-Leitfähigkeitstyp erzeugende Beimischung durch eine dritte Beimischung kompensiert sind, die in der Halbleiterstruktur (1) tiefliegende Energieniveaus bildet und als solche Gold benutzt ist.

4. Halbleiterstruktur nach Anspruch 1 oder 2, **dadurch gekennzeichnet**, dass als Material der Halbleiterstruktur (1) Silizium gewählt ist, das mit einer den n-Leitfähigkeitstyp erzeugenden Beimischung dotiert ist, als welche Phosphor eingesetzt ist, und als die den p-Leitfähigkeitstyp erzeugende Beimischung Aluminium verwendet ist, wobei die den p-Leitfähigkeitstyp erzeugende Beimischung durch eine dritte Beimischung kompensiert sind, die in der Halbleiterstruktur (1) tiefliegende Energieniveaus bildet und als welche Zink benutzt ist.

5. Verfahren zur Steuerung der Leitfähigkeit einer aus einem mit der Beimischung des einen Leitfähigkeitstyps dotierten Werkstoff hergestellten Halbleiterstruktur, in der ein p- n Übergang (3) durch Einlegieren der Beimischung des entgegengesetzten Leitfähigkeitstyps erzeugt ist, wobei die Beimischung des ersten Leitfähigkeitstyps durch Einlegieren einer dritten, tiefliegende Energieniveaus in der Halbleiterstruktur (1) bildenden Beimischung kompensiert sind, darin bestehend, dass in der Halbleiterstruktur (1) ein Stromkanal (7) zwangsweise gebildet wird, **dadurch gekennzeichnet**, dass in der Halbleiterstruktur (1) ein derartiges Verhältnis der Beimischungskonzentrationen gesichert wird, bei dem die Anzahl der durch die Beimischung des ersten Leitfähigkeitstyps erzeugten, durch die dritte Beimischung kompensierten Ladungsträger im wesentlichen gleich der Anzahl der durch die Beimischung des zweiten Leitfähigkeitstyps erzeugten Ladungsträger ist, der Stromwert bei der Stromkanalbildung in einem Bereich eingestellt wird, bei dem in der Halbleiterstruktur (1) eine periodische Änderung der Leitfähigkeit in der Zone des Stromkanals (7) entsteht, die eine Änderung der Leitfähigkeit der gesamten Halbleiterstruktur (1) bewirkt, und am Ausgang der Halbleiterstruktur eine Impulsfolge erzeugt wird.

6. Steuerverfahren für die Leitung einer Halbleiterstruktur nach Anspruch 5, **dadurch gekennzeichnet**, dass die Frequenz der Leitfähigkeitsänderung in der Zone des Stromkanals (7) durch mindestens eine äussere Einwirkung gesteuert wird.

7. Verfahren zur Steuerung der Leitfähigkeit einer aus einem mit der Beimischung des einen Leitfähigkeitstyps dotierten Werkstoff hergestellten Halbleiterstruktur, in der ein p- n Übergang (3) durch Einlegieren der Beimischung des entgegengesetzten Leitungstyps erzeugt ist, wobei die Beimischung des ersten Leitfähigkeitstyps durch Einlegieren einer dritten Beimischung kompensiert sind, die in der Halbleiterstruktur (1) tiefliegende Energieniveaus bildet, darin bestehend, dass in der Halbleiterstruktur (1) ein Stromkanal (7) zwangsweise gebildet und auf die Halbleiterstruktur (1) von aussen eingewirkt wird, **dadurch gekennzeichnet**, dass in der Halbleiterstruktur (1) für ein solches Verhältnis der Beimischungskonzentrationen gesorgt wird, bei dem die Anzahl der durch die Beimischung des ersten Leitfähigkeitstyps erzeugten, durch die dritte Beimischung kompensierten Ladungsträger die Anzahl der durch die Beimischung des zweiten Leitfähigkeitstyps erzeugten Ladungsträger um maximal eine Grössenordnung überschreitet, der Stromwert bei der Stromkanalbildung in einem Bereich eingestellt wird, bei dem in der Halbleiterstruktur (1) bei den äusseren Einwirkungen eine periodische Änderung der Leitfähigkeit in der Stromkakanalzone entsteht, die eine Änderung der Leitfähigkeit in der gesamten Halbleiterstruktur (1) bewirkt, und am Ausgang der Halbleiterstruktur (1) eine Impulsfolge erzeugt wird, deren Wiederholungsfrequenz von der Grösse der Einwirkung abhängt.

8. Steuerverfahren für die Leitung einer Halbleiterstruktur nach Anspruch 5 oder 7, **dadurch**

**gekennzeichnet**, dass der Strombereich, bei dem in der Halbleiterstruktur (1) eine periodische Änderung der Leitfähgkeit in der Zone des Stromkanals(7) entsteht, in Abhängigkeit von den Konzentrationen sämtlicher Beimischungstypen, den geometrischen Abmessungen und Konstruktionsparametern der Halbleiterstruktur (1) gewählt wird.

9. Steuerverfahren für die Leitung einer Halbleiterstruktur nach Anspruch 6 oder 7, **dadurch gekennzeichnet**, dass als äussere Einwirkung ein Magnetfeld ausgenutzt wird, das senkrecht zum Stromkanal (7) in der Halbleiterstruktur (1) gerichtet ist.

10. Steuerverfahren für die Leitung einer Halbleiterstruktur nach Anspruch 6 oder 7, **dadurch gekennzeichnet**, dass als äusere Einwirkung eine mechanische Kraft benutzt wird, die an die Halbleiterstruktur (1) im Bereich der Eingrenzung des Stromkanals (7) angelegt wird.

11. Steuerverfahren für die Leitung einer Halbleiterstruktur nach Anspruch 6 oder 7, **dadurch gekennzeichnet**, dass als äussere Einwirkung eine Lichtstrahlung benutzt wird, die in den Bereich der Eingrenzung des Stromkanals (7) der Halbleiterstruktur (1) gelenkt wird.

12. Steuerverfahren für die Leituug einer Halbleiterstruktur nach Anspruch 6, **dadurch gekennzeichnet**, dass als äussere Einwirkung eine Wärmeeinwirkung ausgenutzt wird, der die Halbleiterstruktur (1) unterzogen wird.

13. Steuerverfahren für die Leitung einer Halbleiterstruktur nach Anspruch 7, **dadurch gekennzeichnet**, dass als äussere Einwirkung mindestens zwei Arten der äusseren Einwirkungen benutzt werden, wobei durch die äussere Einwirkung der einen Art eine periodische Änderung der Leitfähigkeit im Stromkanal (7) hervorgerufen und durch die äussere Einwirkung der anderen Arten die Frequenz dieser Änderung gesteuert wird.

14. Steuerverfahren für die Leitung einer Halbleiterstruktur nach Anspruch 13, **dadurch gekennzeichnet**, dass als mindestens zwei Arten der äusseren Einwirkungen magnetisches Feld, mechanische Kraft, Lichtstrahlung verwendet werden.

15. Fühlelement auf der Basis einer aus einem mit der Beimischung den einen Leitfähigkeitstyps dotierten Werkstoff hergestellten Halbleiterstruktur, in der ein p-n Übergang (3) durch Einlegieren der Beimischung des entgegengesetzten Leitungstyps erzeugt ist, wobei die Beimischung des ersten Leitfähigkeitstyps durch Einlegieren einer dritten Beimischung kompensiert ist, die in der Halbleiterstruktur (1) tiefliegende Energieniveaus bildet, und das Kontakte zum p- und n-Bereich (4 bzw. 2) für den Anschluss an eine Speisequelle (5) und für die Abnahme eines Ausgangssignals enthält, **dadurch gekennzeichnet**, dass es auf der Basis der Halbleiterstruktur (1) hergestellt wird, in der das Verhältnis der Beimischungskonzentrationen so ist, dass die Anzahl der durch die Beimischung des ersten Leitfähigkeitstyps erzeugten Ladungsträger, die durch die dritte Beimischung kompensiert ist im wesentlichen der Anzahl der durch die Beimischung des zweiten Leitungstyps erzeugten Ladungsträger gleich ist.

16. Fühlelement auf der Basis einer aus einem mit der Beimischung des einen Leitfähigkeitstyps dotierten Werkstoff hergestellten Halbleiterstruktur, in der ein p- n Übergang (3) durch Einlegieren der Beimischung des entgegengesetzten Leitfähigkeitstyps erzeugt ist, wobei die Beimischung des ersten Leitfähigkeitstyps durch Einlegieren einer dritten Beimischung kompensiert ist, die in der Halbleiterstruktur (1) tiefliegende Energieniveaus bildet, und das Kontakte zum p- und n-Bereich (4 bzw. 2) für den Anschluss an eine Speisequelle (5) und für die Abnahme eines Ausgangssignals enthält, **dadurch gekennzeichnet**, dass es auf der Basis der Halbleiterstruktur (1) hergestellt wird, in der sich die Beimischungskonzentrationen in einem solchen Verhältnis befinden, dass die Anzahl der durch die Beimischung des ersten Leitfähigkeitstyps erzeugten Ladungsträger, die durch die dritte Beimischung kompensiert ist, die Anzahl der durch die Beimischung des zweiten Leitfähigkeitstyps erzeugten Ladungsträger um maximal eine Grössenordnung übertrifft.

**FIG.1**

**FIG.2**

**FIG.3**

**FIG.4**

FIG.5

FIG.6

# INTERNATIONAL SEARCH REPORT

International Application No PCT/SU 89/00340

**I. CLASSIFICATION OF SUBJECT MATTER** (if several classification symbols apply, indicate all) *

According to International Patent Classification (IPC) or to both National Classification and IPC

Int.Cl.$^5$  H 01 L 29/02

**II. FIELDS SEARCHED**

Minimum Documentation Searched [7]

| Classification System | Classification Symbols |
|---|---|
| Int.Cl.$^4$ | H 01 L 29/02,06,08,207,82,84; 31/02; 43/02 |

Documentation Searched other than Minimum Documentation
to the Extent that such Documents are Included in the Fields Searched [8]

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| A | I.M. Vikulin et al. "Galvanomagnitnye pribory" 1983, Radio i svyaz (Moscow), pages 39-42 | 1-3,6,9,15-16 |
| A | Fizika i tekhnika poluprovodnikov, vol. 8, vyp. 1, January 1974 (Nauka, Leningrad), pages 39-44; N.B. Zaletaev et al. "Vliyanie osveschenia na svoistva s-diodov iz germania s primesju zolota" | 1-3,6,11, 15-16 |
| A | SU, A1, 1161831 (Osoboe konstruktorskoe bjuro pri Fiziko-tekhnicheskom institute AN UzSSR i Fiziko-tekhnichesky institut AN UzSSR), 15 June 1985 (15.06.85) | 1-6,9,15-16 |
| A | Fizika i tekhnika poluprovodnikov, vol. 12, vyp. 6, May 1978 (Nauka, Leningrad), pages 1187-1188, S.A. Azimov et al."Magnitochuvstvitelnye diody iz kremnia, kompensirovannogo iridiem" | 1-4,15-16 |
| A | Fizika i tekhnika poluprovodnikov, vol. 10, vyp. 3, March 1976 (Nauka, Leningrad), pages 511-517, | 5-8 |

/.

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

**IV. CERTIFICATION**

| Date of the Actual Completion of the International Search | Date of Mailing of this International Search Report |
|---|---|
| 19 June 1990 (19.06.90) | 30 July 1990 (30.07.90) |
| International Searching Authority | Signature of Authorized Officer |
| ISA/SU | |

Form PCT/ISA/210 (second sheet) (January 1985)

-2-

| III. DOCUMENTS CONSIDERED TO BE RELEVANT | (CONTINUED FROM THE SECOND SHEET) | |
|---|---|---|
| Category* | Citation of Document, with indication, where appropriate, of the relevant passages | Relevant to Claim No |
| | P.T. Oreshkin et al."Nekotorye svoistva shnurov toka v diodnykh strukturakh na osnove stekloobraznykh poluprovodnikov" | |
| A | Fizika i tekhnika poluprovodnikov, vol. 19, vyp. 7, July 1985 (Nauka, Leningrad), pages 1334-1335, V. Blonskis et al."Neustoichivost shnura toka v poperechnom magnitnom pole v kremnievykh n+ - n - n+ - strukturakh s razlichnymi ploschadyami perekhodov" | 1-3,5-8,12 15-16 |
| A | Fizika i tekhnika poluprovodnikov, vol. 18, vyp. 8, May 1984 (Nauka, Leningrad), pages 1383-1385 A.T. Gorelenok et al. "Osobennosti razvitia tokovykh shnurov v poluprovodnikakh" | 5-9 |

---------

Form PCT/ISA/210 (extra sheet) (January 1985)